# EUROPEAN PATENT APPLICATION

(11) **EP 4 203 317 A1**
(43) Date of publication of application: **28.06.2023**
(21) Application number: 21218425.3
(22) Date of filing: 31.12.2021
(51) Int. Cl.: H03K 17/96, H03K 17/955, E05B 81/76

(54) **A SENSOR ASSEMBLY FOR VEHICLE DOOR HANDLE**

(30) Priority: 22.12.2021 TR 202120659
(71) Applicant: Saykal Elektronik Anonim Sirketi, Kocaeli (TR)
(72) Inventor: SAYKAL, Yucel, Kocaeli (TR); OZDEMIR, Emre, Kocaeli (TR); AKPINAR, Enes Ahmet, Kocaeli (TR); SIRMA, Anil, Kocaeli (TR); BICAN, Ismail, Kocaeli (TR); AYABAKAN, Mehmet Murat, Kocaeli (TR); YILMAZ, Ersoy, Kocaeli (TR); ATAK, Kerim, Kocaeli (TR)
(74) Representative: Kaya, Erdem

(57) **Abstract**

The invention is a sensor assembly (100) to be integrated into a vehicle door handle, comprising a capacitive sensor unit (140); a processor unit configured to detect that there is an object with a capacitive load approaching a vehicle door handle and/or contacting a vehicle door handle based on signals received from said capacitive sensor unit (140). Accordingly, it is characterized in that it includes a sensor chamber (110) provided in said door handle; a circuit board (130) provided in the sensor chamber (110); the control unit (160) and said capacitive sensor unit (140) being provided on said circuit board (130); a sealing layer (120) surrounding the circuit board (130) such that it cuts off the contact of said circuit board (130) with the external environment.

## Description

### TECHNICAL FIELD

The invention is a sensor assembly to be integrated into a vehicle door handle, comprising a capacitive sensor unit; a processor unit configured to detect that there is an object with a capacitive load approaching a vehicle door handle and/or contacting a vehicle door handle based on signals received from said capacitive sensor unit.

### PRIOR ART

Vehicle door handles allow access to the vehicle. In the present art, the door handle can be activated by detecting people approaching the door handle or contacting the door handle with capacitive sensors.

The capacitance values measured by the assemblies in this type of door handles can be affected by factors such as humidity, temperature and electromagnetic interference, and may cause inaccurate measurements.

In the DE document numbered DE102005034035, a door handle with a structure similar to the one described above is described.

As a result, all issues mentioned above made it necessary to make an innovation in the relevant technical field.

### BRIEF DESCRIPTION OF THE INVENTION

The present invention relates to a movable sensor assembly in order to eliminate the above mentioned disadvantages and bring new advantages to the relevant technical field.

An object of the invention is to provide a sensor assembly in which the correct detection of objects that are in contact with or approaching it is affected in a reduced manner by humidity, temperature and electromagnetic interference.

In order to realize all the objects mentioned above and which will emerge from the detailed description below, the present invention is a sensor assembly to be integrated into a vehicle door handle, comprising a capacitive sensor unit; a processor unit configured to detect that there is an object with a capacitive load approaching a vehicle door handle and/or contacting a vehicle door handle based on signals received from said capacitive sensor unit. Accordingly, its novelty is that it includes a sensor chamber provided in said door handle; a circuit board provided in the sensor chamber; that the control unit and said capacitive sensor unit is provided on said circuit board; it comprises a sealing layer surrounding the circuit board such that it cuts off the contact of said circuit board with the external environment. Thus, it is ensured to produce the signal that the object is approaching or the object is in contact with an increased accuracy by ensuring that the sensor is affected by external influences in a reduced amount. In addition, since the components are provided on a single circuit board, the conductive paths are shortened and an accelerated response is provided.

A possible embodiment of the invention is characterized in that said sealing layer contains epoxy.

Another possible embodiment of the invention is characterized in that said sealing layer contains epoxy resin.

Another possible embodiment of the invention is characterized in that the said sealing layer is an epoxy resin provided to fill the sensor chamber.

Another possible embodiment of the invention is characterized in that said circuit board includes a capacitive digital converter provided between the control unit and the capacitive sensor unit. Thus, the capacitive load formed on the copper plates is converted into digital value. The processor control unit detects the capacitive changes that occur by communicating with this unit.

Another possible embodiment of the invention is characterized in that it includes a temperature sensor associated with the control unit to measure the ambient temperature; the control unit is configured to apply a filtering process to the temperature measurements it receives, to apply a baseline tracking algorithm to the temperature measurements it receives and to the signal it receives from the capacitive sensor unit, to detect contacting the door or approaching to the door according to the results obtained from the baseline tracking algorithm.

### BRIEF DESCRIPTION OF THE FIGURES

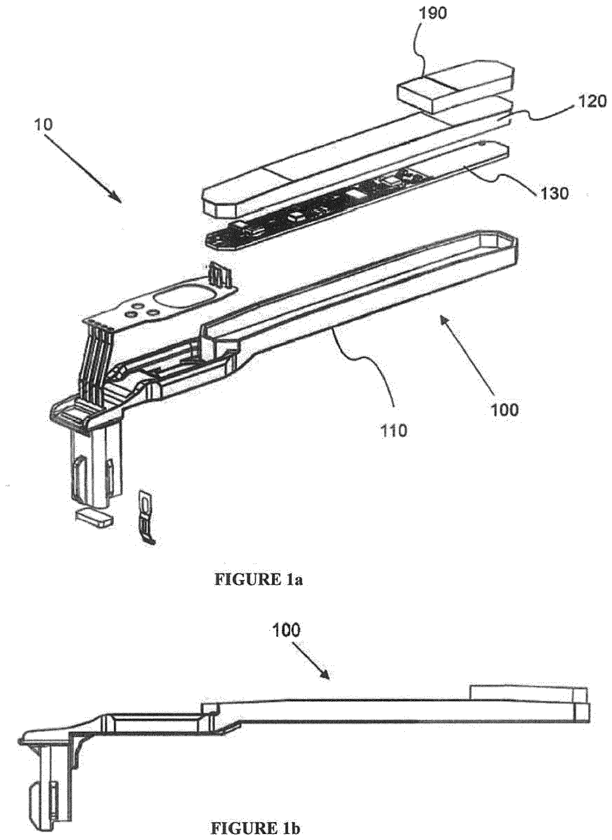

A representative view of the sensor assembly is given in Figure 1a.

A representative side view of the door handle is given in Figure 1b.

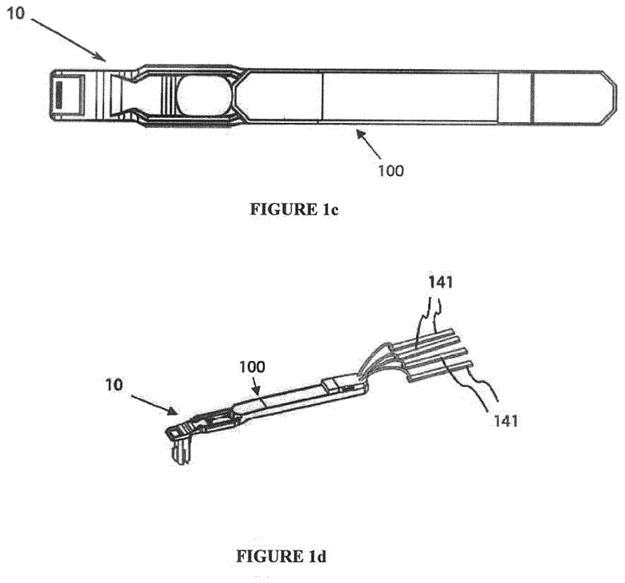

A representative top view of the door handle is given in Figure 1c.

Figure 1d shows an embodiment of the sensor assembly in which copper electrodes are provided externally.

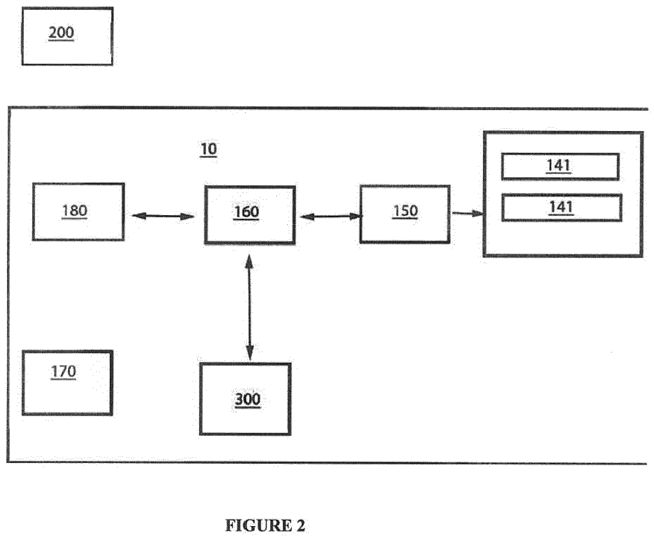

A schematic view of the components of the door handle is given in Figure 2.

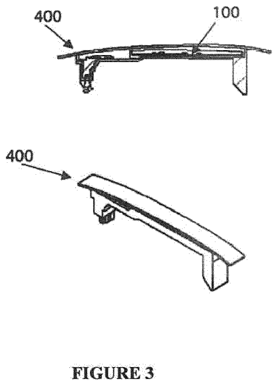

Figure 3 shows a representative view of the sensor assembly integrated into a vehicle door handle.

### DETAILED DESCRIPTION OF THE INVENTION

In this detailed description, the subject matter of the invention is described by using examples only for a better understanding, which will have no limiting effect.

With reference to Figure 1a, the invention is a sensor assembly (100) provided to detect objects that approach enough or come into contact with the vehicle door handle by integrating into vehicle door handles.

The sensor assembly (100) of the invention includes a capacitive sensor unit (140); a control unit (160) to detect contact with the door handle or an object approaching the door handle by utilizing the change in capacitance according to the signals received from said capacitive sensor unit (140). When the control unit (160) detects contact or an approaching object, it generates a signal and sends this signal to a unit that controls the opening of the door handle (for example, the vehicle ECU), thus it allows the door to be opened or any pre-programmed action to be performed. The object mentioned here is an object with a capacitive load. For example, a limb of a person who will use the door handle is an object with a capacitive load.

The control unit (160) may be a processor such as a microprocessor or another type of processor.

The control unit (160) and the capacitive sensor unit (140) are provided to be connected to each other via conductive paths on the same board. Thus, the conductive path between the sensor and the processor unit is kept at a minimum, thus the amount of EMI exposure is reduced, the data transfer rate is increased and the response time of the sensor is shortened.

The sensor assembly (10) includes a sensor chamber (110) provided in the vehicle door handle. The sensor chamber (110) is arranged to contain the circuit board (130).

As one of the innovative features of the invention, a sealing layer (120) surrounding the circuit board (130) is provided to cut off the contact of the circuit board (130) with the external environment. In a possible embodiment of the invention, said sealing layer (120) comprises epoxy. In another embodiment of the invention, the sealing layer (120) is epoxy resin. The sealing layer (120) can be formed by filling the liquid epoxy resin after the board is placed in the chamber. Thus, the contact of the board with the external environment is cut off, and the amount of measurement being affected by external conditions is reduced.

In a possible embodiment of the invention, the sealing layer (120) is associated with the circuit board (130) by the method of placing the circuit board (130) in an injection pool and applying plastic injection process to the injection pool. Then, this combined structure can be placed in the sensor chamber (110).

The sensors mentioned here are placed on the circuit considering the environmental effects and other factors mentioned before.

The capacitive sensor unit (140) includes copper electrodes (141). The copper electrodes (141) are in number and arrangement to form at least one capacitor. The copper electrodes can be provided in the form of plate. For example, there may be 4 copper electrodes (141). With reference to figure 2, the copper electrodes may be in the sensor unit (140), in other words on the circuit board (130). In another embodiment of the invention, the copper electrodes (141) can be provided externally from the circuit board (130) in the vehicle body or around the door handle. In another embodiment of the invention, some of the copper electrodes (141) are provided on the circuit board (130), while the other part is provided on the vehicle body or around the door handle, externally from the circuit board (130). In the sensor unit (140), the capacitance measuring component associated with the copper electrodes (141) is of the EMI compatible type.

With reference to Figure 1d, in one possible embodiment of the invention, the embodiment is shown in which the sensor unit (140) is provided on the circuit board (130) while the copper electrodes (141) are provided externally from the circuit board (130).

The control unit (160) can generate a signal indicating that an object is approaching the vehicle door handle or that an object is in contact with the vehicle door handle, the signal it receives from the copper plates, and can enable the door to open by sending this signal to the processor/controller that controls the door handle. The control unit (160) is able to filter the signals it receives. These filters are known in the art as digital filters. These are filters known in the art that consist of command lines executed by the control unit (160) and provide appropriate filtering of digital data. In this way, the noise in the incoming signals in the measurements of the sensor is reduced. At the same time, the values related to the low filter can be changed with the software. In these processes, the detection distance is adjusted with threshold values. The value of the capacitive load coming from the sensor increases as the human hand approaches. At the same time, the required level for the capacitive load to trigger the communication or outputs of the device can be adjusted at the desired level.

External factors such as temperature and humidity can affect the measurement values taken from the capacitive sensor unit (140) over time, even if there is no object contacting the door handle or approaching the door handle. For example, the values taken from the capacitive sensor unit (140) may also change depending on the temperature or humidity change. Therefore, the object contact inspection, which is made by detecting whether a fixed reference value of the object presence is exceeded, may be erroneous when the ambient conditions change. External factors such as temperature and water cause a change in the capacitive load value coming from the sensor.

With reference to Figure 2, the sensor assembly (100) further includes a temperature sensor (170) associated with the control unit (160). Said temperature sensor (170) provides instant monitoring of the ambient temperature. The control unit (160) evaluates the signals coming from the temperature sensor (170) and from the capacitive sensor unit (140) by *"baseline tracking algorithm"* which is a method known in the art. The control unit (160) constantly monitors the immediate data coming from the sensor of the device by *"baseline tracking algorithm"* and prevents the system from making a wrong decision in case the incoming data changes due to external factors and from generating a wrong signal.

Response time is defined as the time elapsed between detection and signal generation by the device. Although the time available in the art is 100-120 ms, this time can be reduced to 60-80 ms with the invention. This time depends on several parameters. The rate of rise of the capacitive load depends on the circuit of the sensor used. Since the components being located on the same board reduces the conductor path length, the response time of the system is also reduced.

The insulation of the sensor connector used in the circuit board (130) is provided with liquid silicone seal and epoxy filler.

With reference to Figure 2, the sensor assembly (100) includes a power converter (180) connected to a vehicle power and communication connection (200) for operation of the components. The sensor assembly (100) includes a vehicle communication interface (300) for the control unit (160) to communicate with the vehicle electronic control unit. The vehicle communication interface can be connected to the CAN connection.

The sensor assembly (100) further includes a sponge (190). The said sponge (190) ensures that the circuit board (130) and other components at least partially dampen vibrations within the door handle.

Figure 4 shows a cross-section and perspective view of the sensor assembly (100) integrated into an exemplary door handle (400).

The scope of the protection of the invention is set forth in the annexed claims and certainly cannot be limited to exemplary explanations in this detailed description. It is evident that skilled person in the art can provide similar embodiments in the light of the explanations above without departing from the main theme of the invention.

### REFERENCE NUMBERS IN THE FIGURE

- 100: Sensor assembly
- 110: Sensor chamber
- 120: Sealing layer
- 130: Circuit board
- 140: Capacitive sensor unit
- 141: Copper electrodes
- 150: Capacitive digital converter
- 160: Control unit
- 170: Temperature sensor
- 180: Power converter
- 190: Sponge
- 200: Vehicle power and communication connection
- 300: Vehicle communication interface
- 400: Exemplary door handle

## Claims

1. A sensor assembly (100) to be integrated into a vehicle door handle, comprising a capacitive sensor unit (140); a processor unit configured to detect that there is an object with a capacitive load approaching a vehicle door handle and/or contacting a vehicle door handle based on signals received from said capacitive sensor unit (140), ***characterized in that*** it includes a sensor chamber (110) provided in said door handle; a circuit board (130) provided in the sensor chamber (110); the control unit (160) and said capacitive sensor unit (140) being provided on said circuit board (130); a sealing layer (120) surrounding the circuit board (130) such that it cuts off the contact of said circuit board (130) with the external environment.

2. A sensor assembly (100) according to claim 1, ***characterized in that*** said sealing layer (120) contains epoxy.

3. A sensor assembly (100) according to claim 1, ***characterized in that*** said sealing layer (120) contains epoxy resin.

4. A sensor assembly (100) according to claim 1, ***characterized in that*** said sealing layer (120) is epoxy resin provided to fill the sensor chamber (110).

5. A sensor assembly (100) according to claim 1, ***characterized in that*** said circuit board (130) includes a capacitive digital converter (150) provided between the control unit (160) and the capacitive sensor unit (140).

6. A sensor assembly (100) according to claim 1, ***characterized in that*** it includes a temperature sensor (170) associated with the control unit (160) for measuring ambient temperature; the control unit (160) is configured to
- apply a filtering process to the temperature measurements it takes,
- apply a baseline tracking algorithm to the temperature measurements it receives and the signal it receives from the capacitive sensor unit (140),
- detect door contact or approaching to the door based on the results obtained from the baseline tracking algorithm.
